# FASCICULE DE BREVET EUROPEEN

(11) **EP 3 520 587 B1**
(45) Date de publication et mention de la délivrance du brevet: **01.12.2021**
(21) Numéro de dépôt: 17781054.6
(22) Date de dépôt: 28.09.2017
(51) Int. Cl.: H05K 7/14

(54) **UNITE ELECTRONIQUE A MODULES INVERSABLES**
ELEKTRONISCHE EINHEIT MIT REVERSIBLEN MODULEN
ELECTRONIC UNIT WITH REVERSIBLE MODULES

(30) Priorité: 30.09.2016 FR 1659476
(43) Date de publication de la demande: 07.08.2019
(73) Titulaire: Safran Electronics & Defense, 75015 Paris (FR); Safran Electrical & Power, 31702 Blagnac Cedex (FR)
(72) Inventeur: GUILLOT, François, 77550 MOISSY-CRAMAYEL (FR); BLINEAU, Jean-Marc, 31702 Blagnac Cedex (FR); AVIGNON, Philippe, 31702 Blagnac Cedex (FR); ROQUES, Serge, 31702 Blagnac Cedex (FR); ALBERO, Franck, 31702 Blagnac Cedex (FR)
(74) Mandataire: Prouvez, Julien
(86) Numéro de dépôt international: PCT/EP2017/074723
(87) Numéro de publication internationale: WO 2018/060389

(56) Documents cités:
- EP-A1- 3 024 309
- FR-A1- 2 783 392
- FR-A1- 3 007 239
- US-A1- 2002 012 236
- US-B1- 7 643 309

## Description

La présente invention concerne le domaine de l'électronique en général mais aussi, plus particulièrement, celui des unités de calcul aéronautiques.

### ETAT DE LA TECHNIQUE

Il est connu des unités de calcul ou baies comprenant chacune un boîtier définissant un compartiment contenant des modules de calcul insérables dans le compartiment selon une direction d'insertion par une ouverture de celui-ci et raccordables à des connecteurs portés par une paroi de fond du compartiment pour déboucher dans le compartiment à l'opposé de l'ouverture. Par « module de calcul », on entend tout circuit électronique susceptible de traiter des signaux et/ou des données, et notamment de faire des calculs sur ces signaux ou ces données. Le circuit électronique peut être constitutif d'un ordinateur et comprendre un ensemble de processeurs de type ASIC ou autre, un réseau programmable de type FPGA... Dans une application aéronautique, les modules de calcul sont principalement reliés aux instruments de commande sur lesquels agit le pilote de l'aéronef, à des indicateurs pour l'information du pilote, à des capteurs répartis dans l'aéronef et à des équipements de l'aéronef.

La recherche de l'optimisation de l'utilisation des unités électroniques et de l'occupation de l'espace dans l'aéronef tend à rechercher plus de modularité dans la constitution des unités électroniques.

Le document US2002/012236 et le document EP3024309 décrivent tous deux une unité électronique comprenant un boitier délimitant un compartiment de réception de modules électronique selon un unique sens d'une direction d'introduction. La connexion des cartes des modules se fait sur des connecteurs solidaires d'un panneau arrière du boitier. Ces solutions ne représentent pas des solutions satisfaisantes aux besoins de modularité dans la constitution des unités électroniques.

### OBJET DE L'INVENTION

Un but de l'invention est de fournir une solution à ce problème.

### BREF EXPOSE DE L'INVENTION

A cet effet, on prévoit, selon l'invention, une unité électronique comprenant un boîtier délimitant un compartiment de réception d'un module électronique selon deux sens opposés l'un à l'autre d'une direction d'introduction. Le compartiment comprend des moyens d'alimentation électrique du module électronique et des moyens de connexion de l'unité électronique au module électronique, ces moyens débouchant sur une face de branchement appartenant au compartiment s'étendant parallèlement à la direction d'introduction.

Une telle configuration de l'unité électronique permet une installation et un montage aisé d'un module électronique indépendamment de l'orientation de l'unité électronique par rapport à une cloison ou un accès de maintenance. La même unité électronique peut alors être utilisée pour équiper des espaces d'accueil de l'unité électronique confinés et dans lesquels les unités électroniques seraient placées symétriquement l'une par rapport à l'autre.

Avantageusement, les moyens d'alimentation comprennent une première plage conductrice et une deuxième plage conductrice disposées de part et d'autre d'une ligne médiane de la face de branchement, une des première et deuxième plages conductrices étant le pôle positif de l'alimentation électrique du module électronique, l'autre des première et deuxième plages conductrices étant le pôle négatif de l'alimentation électrique du module électronique.

Ainsi, une rotation du module électronique autour d'un axe perpendiculaire à la face de branchement, préalablement à son introduction dans le compartiment provoque une inversion de la polarité du courant d'alimentation reçu par le module électronique.

Avantageusement encore, la face de branchement de l'unité électronique au module électronique comprend au moins partiellement un revêtement réduisant les frottements.

Ceci permet une introduction plus aisée du module électronique dans le compartiment. Ceci est particulièrement pratique lorsqu'une face du compartiment opposée à la face de branchement comprend au moins un élément élastique agencé pour exercer un effort selon une direction sensiblement perpendiculaire au plan de la face de branchement, afin d'éviter les vibrations du module électronique dans le compartiment.

Les moyens de connexion du module électronique à l'unité électronique peuvent comprendre un coupleur magnétique et/ou un coupleur optique.

L'invention concerne également un module électronique comprenant deux extrémités d'introduction dans un compartiment d'une unité électronique selon deux sens opposés d'une direction d'introduction, des moyens de liaison à une alimentation électrique et des moyens de connexion à l'unité électronique, les moyens de liaison à une alimentation électrique et les moyens de connexion à l'unité électronique débouchant sur une face de branchement appartenant à l'unité électronique, la face de branchement s'étendant parallèlement à la direction d'introduction.

Un tel module électronique peut être installé aisément dans un compartiment d'une unité électronique indépendamment de l'orientation de l'unité électronique par rapport à une cloison ou un accès de maintenance. Le même module électronique peut alors être utilisé pour équiper des unités électroniques qui seraient placées symétriquement l'une par rapport à l'autre.

Avantageusement, les moyens de liaison à une alimentation électrique comprennent des moyens pour restituer une polarité d'alimentation constante quelle que soit la polarité de la tension appliquée aux moyens de liaison à une alimentation électrique.

Ainsi quelle que soit la polarité de l'alimentation appliquée à l'entrée des moyens de liaison à une alimentation électrique, le module électronique n'est pas endommagé et peut fonctionner normalement

Avantageusement encore, le module électronique comprend des moyens reliés aux moyens de liaison à une alimentation électrique et conformés pour modifier un sens de communication des moyens de connexion au dispositif.

Ainsi le sens de communication des moyens de connexion du module électronique peut être modifié en fonction de l'orientation du module électronique relativement au logement.

L'invention s'applique également à un module électronique comprenant au moins une extrémité d'introduction dans un compartiment d'une unité électronique selon deux sens opposés d'une direction d'introduction, des moyens de liaison à une alimentation électrique et des moyens de connexion à l'unité électronique, les moyens de liaison à une alimentation électrique et les moyens de connexion à l'unité électronique débouchant sur une face de branchement appartenant au module électronique, la face de branchement s'étendant parallèlement à la direction d'introduction.

L'invention s'applique également à un aéronef comprenant un fuselage comprenant plusieurs unités électroniques décrites ci-avant et réparties dans le fuselage, le fuselage étant divisé par un plancher en un volume supérieur et un volume inférieur dans lequel s'étendent des poutrelles supportant le plancher et délimitant avec le fuselage et le plancher deux logements latéraux qui ont une section transversale sensiblement triangulaire et qui s'étendent parallèlement à une direction longitudinale du fuselage, les unités électroniques étant disposées dans au moins l'un des logements latéraux.

D'autres caractéristiques et avantages de l'invention ressortiront à la lecture de la description qui suit de modes de réalisation particuliers non limitatifs de l'invention.

### BREVE DESCRIPTION DES FIGURES

Il sera fait référence aux dessins annexés, parmi lesquels :

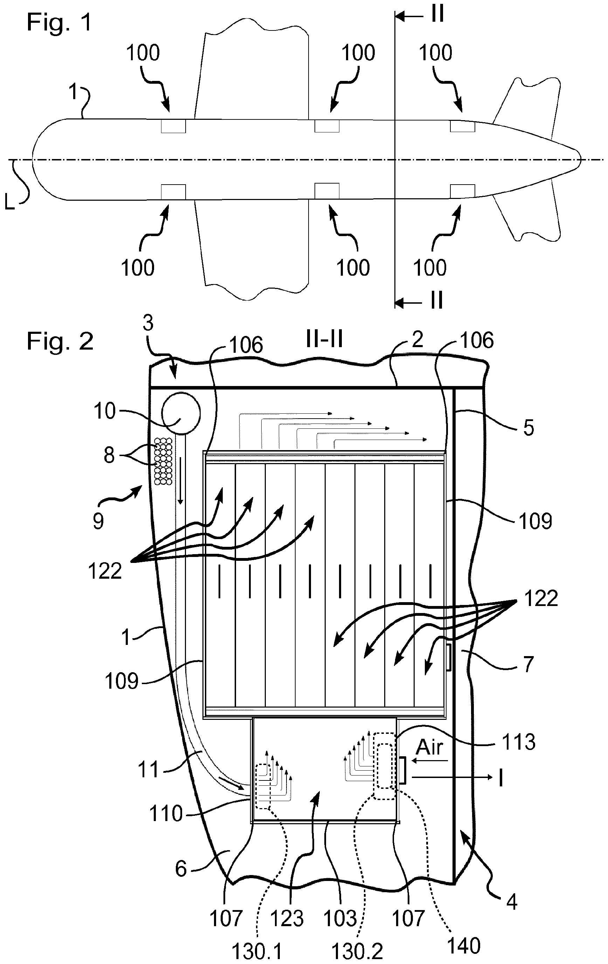

- la figure 1 est une vue schématique d'un aéronef selon l'invention ;
- la figure 2 est une vue schématique en coupe de cet aéronef selon la ligne II de la figure 1 ;

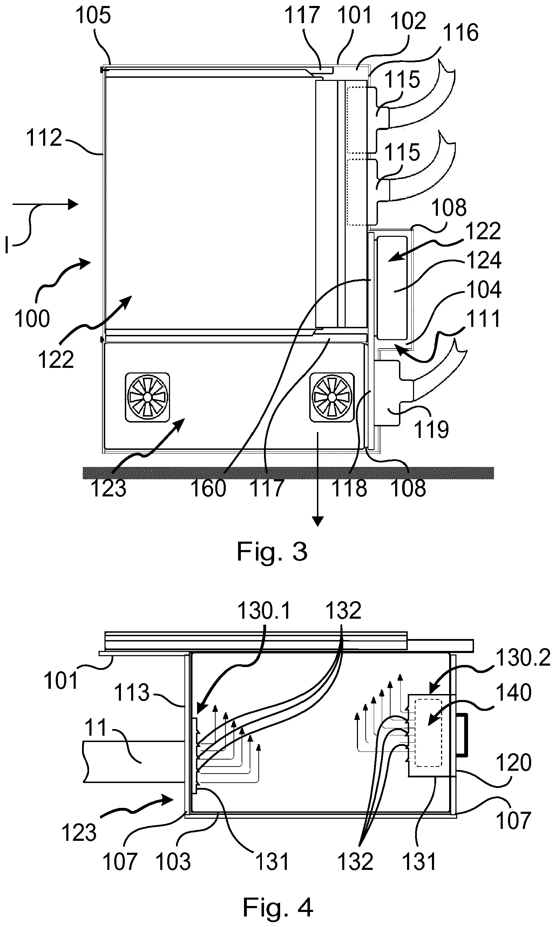

- la figure 3 est une vue schématique de côté d'une unité de calcul selon l'invention ;
- la figure 4 est une vue schématique agrandie et en coupe selon le plan II de la figure 1 du module commun de refroidissement et d'alimentation ;

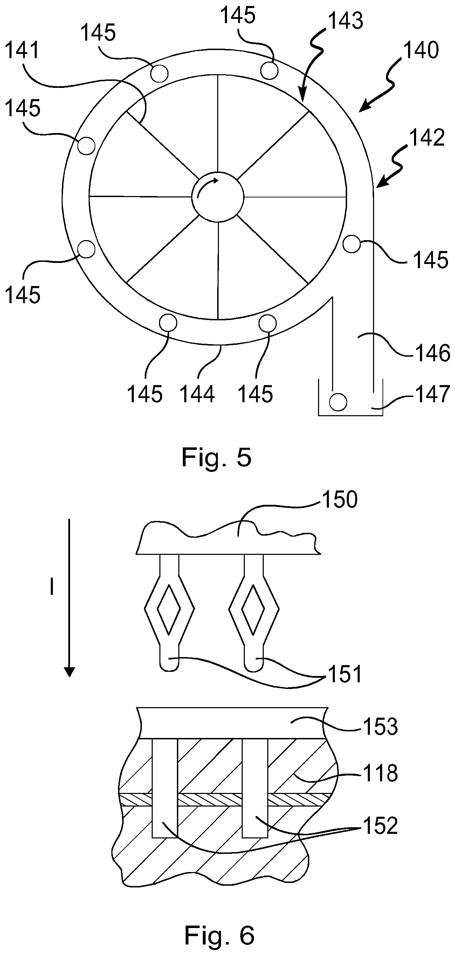

- la figure 5 est une vue schématique de face d'un ventilateur de ce module commun de refroidissement et d'alimentation ;
- la figure 6 est une vue en coupe transversale montrant le raccordement d'un des modules de calcul à une plaque de circuit imprimé ;
- la figure 7 est une vue partielle en perspective d'un compartiment d'une unité de calcul et d'un premier type de module électronique destiné à y être monté ;
- la figure 8 est une vue schématique d'un circuit électronique d'un premier type de module électronique selon l'invention ;
- la figure 9 est une vue schématique en perspective d'un deuxième type de module électronique selon l'invention ;
- la figure 10 est une vue identique à la figure 1 sur laquelle sont représentés les modules électroniques avant leur installation dans les unités de calcul ;
- la figure 11 est une vue de détail en coupe selon un plan XI-XI de la figure 7, pour montrer une étape de montage d'un module électronique dans une unité de calcul selon l'invention ;
- la figure 12 est une vue de détail en coupe selon le plan XI-XI d'un module électronique monté dans une unité de calcul selon l'invention ;
- la figure 13 est une vue schématique d'une face de branchement d'un mode de réalisation particulier d'une unité de calcul selon l'invention ;
- la figure 14 est une vue, en coupe longitudinale selon un plan XIV-XIV de la figure 13, de cette unité de calcul ;
- la figure 15 est une vue schématique d'une face de branchement d'un module commun selon un mode de réalisation particulier de l'invention ;
- la figure 16 est une vue, en coupe selon le plan XIV-XIV, montrant l'assemblage de l'unité de calcul de la figure 14 et le module commun de la figure 15.
- la figure 17 est une vue similaire à celle de la figure 16 montrant une première étape de dépose du module commun ;
- la figure 18 est une vue similaire à celle de la figure 16 montrant une deuxième étape de dépose du module commun ;
- la figure 19 est une vue similaire à celle de la figure 16 montrant une troisième étape de dépose du module commun.

### DESCRIPTION DETAILLEE DE L'INVENTION

En référence aux figures, l'aéronef comprend généralement un fuselage 1 divisé par un plancher 2 en un volume supérieur 3 et un volume inférieur 4. Le volume supérieur 3 est destiné à recevoir des sièges pour accueillir des voyageurs et constitue la cabine de l'aéronef ; le volume inférieur 4 est destiné à recevoir les bagages des voyageurs ou du fret et constitue la soute de l'aéronef.

Dans le volume inférieur 4 s'étendent des poutrelles 5 supportant le plancher 2 et délimitant avec le fuselage 1 et le plancher 2 deux logements latéraux 6 qui ont une section transversale sensiblement triangulaire et qui s'étendent parallèlement à une direction longitudinale L du fuselage 1 de part et d'autre d'une zone médiane ou centrale 7. Dans les logements latéraux 6 courent sous le plancher 2 des câbles 8 du faisceau électrique 9 de l'aéronef et l'une des conduites principales ou tubulure 10 de climatisation transportant l'air soufflé dans le volume supérieur 3 pour le climatiser. Le faisceau électrique 9 comprend des câbles utilisés pour la transmission de puissance et des câbles pour la transmission de signaux de commande et de données.

L'aéronef comprend des unités de calcul 100 comprenant chacune un boîtier 101 définissant un compartiment principal 102, un premier compartiment auxiliaire 103 s'étendant sous le compartiment principal 102 et un deuxième compartiment auxiliaire 104 s'étendant derrière une partie supérieure du premier compartiment auxiliaire 103 et derrière une partie inférieure du compartiment principal 102. Le boîtier 101 comprend une ouverture frontale 105 d'accès au compartiment principal 102 ; deux ouvertures latérales 106 d'accès au compartiment principal 102 ; deux ouvertures latérales 107, à l'opposé l'une de l'autre, d'accès au premier compartiment auxiliaire 103 ; et deux ouvertures latérales 108, à l'opposé l'une de l'autre, d'accès au deuxième compartiment auxiliaire 104. L'ouverture frontale 105 est laissée ouverte ; les ouvertures latérales 106 sont fermées par un panneau amovible 109 ; les ouvertures latérales 107, 108 orientées vers la zone médiane 7 sont laissées ouvertes ; les ouvertures latérales 107, 108 orientées à l'opposé de la zone médiane 7 sont fermées par un panneau amovible 110, 111. Les panneaux amovibles sont maintenus en position fermée par un mécanisme de verrouillage rapide ou par des vis. Les panneaux 110, 111 peuvent être montés sur l'une ou l'autre des ouvertures latérales 107, 108 selon le sens de montage de l'unité de calcul 100 dans le logement latéral 6 comme on le verra dans la suite.

Le compartiment principal 102 contient des modules de calcul, généralement désignés en 122 ; le premier compartiment auxiliaire 103 contient un module commun, généralement désigné en 123, de refroidissement et d'alimentation des modules de calcul 122 ; et le deuxième compartiment auxiliaire 104 contient un module commun, généralement désigné en 124, d'interconnexion des modules de calcul 122. Les modules communs 123, 124 assurent une fonction transversale pour les modules de calcul 122.

Les modules de calcul 122 sont insérables dans le compartiment principal 102 selon une direction d'insertion I par l'ouverture frontale 105 du boîtier 101 et sont raccordables à des connecteurs 115 portés par une paroi de fond 116 du boîtier 101 de manière à déboucher dans le compartiment principal 102 à l'opposé de l'ouverture frontale 105. Les modules de calcul 122 ont une face avant en débord qui est fixée sur le boîtier 101 et qui obture partiellement l'ouverture 105 (cette ouverture étant totalement obturée lorsque tous les modules de calcul 122 sont en place). Les connecteurs 115 sont reliés à des câbles du faisceau électrique 9 principalement dédiés à la transmission de signaux de commande et de données de manière à relier les modules de calcul 122 principalement aux instruments de commande sur lesquels agit le pilote de l'aéronef, à des indicateurs pour l'information du pilote, à des capteurs répartis dans l'aéronef et à des équipements de l'aéronef. Les modules de calcul 122 comprennent une plaque de circuit imprimé portant des composants électroniques de commande et/ou de puissance : ils sont connus en eux-mêmes et ne seront pas plus détaillés ici. Les modules de calcul 122 portent également sur leur bord opposé à l'ouverture 105 un connecteur permettant leur raccordement à un connecteur porté par une face d'une plaque de circuit imprimé 118 qui sépare la partie inférieure du fond du compartiment principal 102 et le second compartiment auxiliaire 104 et se prolonge jusque dans le premier compartiment auxiliaire 103. Les modules de calcul 122 sont montés dans le compartiment principal 102 par l'intermédiaire de glissières 117 qui sont fixées dans le boîtier 1 pour s'étendre perpendiculairement à l'ouverture 105 et donc parallèlement à la direction d'insertion I. Les glissières 117 sont en matériau thermiquement conducteur pour drainer par conduction une partie de la chaleur produite par les composants électroniques des modules de calcul 122 vers le boîtier 101. Le boîtier 101 est à cette fin réalisé au moins en partie en matériau thermiquement conducteur de manière à permettre une évacuation vers l'extérieur de la chaleur produite par le fonctionnement des modules de calcul 122. En outre, le boîtier est pourvu d'ouvertures sur sa paroi supérieure pour permettre l'échappement d'un flux convectif.

Le connecteur des modules de calcul 122 permettant leur raccordement à la plaque de circuit imprimé 118 comporte un support 150 en saillie duquel s'étendent, parallèlement à la direction d'insertion I, des broches 151 élastiquement déformables dans un plan transversal à leur axe longitudinal entre un état de relâchement et un état déformé, les broches 151 ayant une section transversale plus importante dans l'état de relâchement que dans l'état déformé. Le connecteur correspondant de la plaque de circuit imprimé 118 comprend des trous métallisés 152 destinés chacun à accueillir une des broches 151 qui est engagée à force dans le trou métallisé et s'y trouve serrée dans son état déformé. La plaque de circuit imprimé 118 n'est pas placée dans une enceinte étanche contre les poussières. Dans un avion à fuselage de carbone, il existe un risque que des poussières de carbone se déposent sur la plaque de circuit imprimé et créent des courts-circuits. Pour éviter cela, la plaque de circuit imprimé 118 est recouverte d'une couche de matériau électriquement isolant 153 qui est percée par les broches 151 lorsque celles-ci sont engagées dans les trous métallisés 152. Lorsque les modules de calcul 122 sont connectés à la plaque de circuit imprimé 118, la couche de matériau électriquement isolant 153 est serrée entre les supports 150 et la plaque de circuit imprimé 118, ce qui tend à refermer les déchirures occasionnées par les broches 151 et empêche les poussières de s'introduire entre les modules de calcul 122 et la plaque de circuit imprimé 118. Le matériau électriquement isolant est ici un silicone et plus particulièrement un silicone vulcanisable à température ambiante (ou RTV pour « Room Temperature Vulcanization »). Bien entendu, tout matériau ayant un comportement élastomérique peut être utilisé, et notamment d'autres types de silicone.

Le module commun 123 est inséré dans le premier compartiment auxiliaire 103 par l'ouverture latérale 107 orientée vers la zone médiane 7 selon une direction d'insertion P perpendiculaire à la direction d'insertion I. Le module commun 123 a une face avant 112 en débord qui est fixée sur le boîtier 101 et qui obture l'ouverture 107.

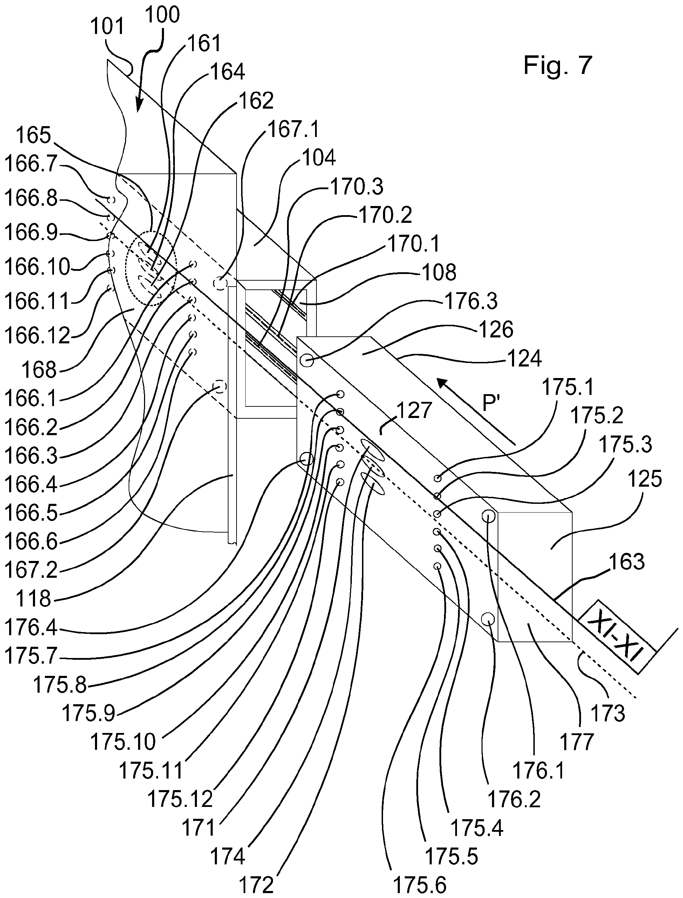

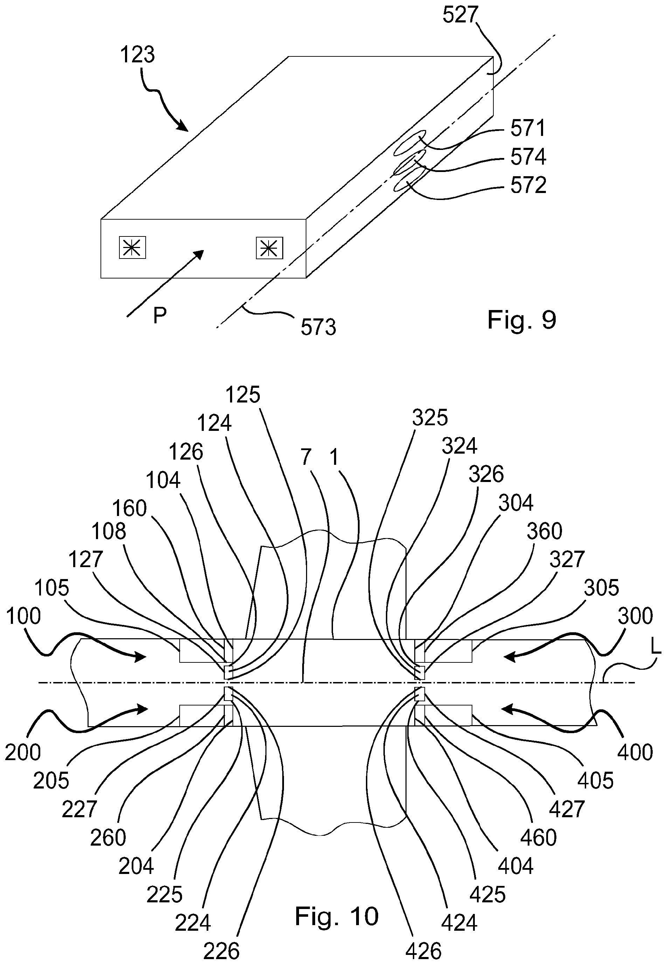

Comme visible sur les figures 7 et 10, le module commun 124 est inséré dans le deuxième compartiment auxiliaire 104 par l'ouverture latérale 108 orientée vers la zone médiane 7 selon une direction d'insertion P' perpendiculaire à la direction d'insertion I. Le module commun 124 a une face avant en débord qui est fixée sur le boîtier 101 et qui obture l'ouverture 108.

Les modules communs 123 et 124 portent tous deux des contacts flexibles leur permettant d'être raccordés à des plages conductrices de la plaque de circuit imprimé 118 qui est elle-même raccordée, d'une part, aux modules de calcul 122 comme cela a été mentionné plus haut et, d'autre part, à un connecteur 119 porté par la paroi de fond 116 et relié à des câbles de puissance et de commande du faisceau électrique 9.

Les contacts flexibles sont disposés de part et d'autre d'une ligne médiane parallèle à la direction d'insertion de telle manière que les contacts destinés à recevoir l'alimentation comportent un pôle positif et un pôle négatif s'étendant selon une ligne perpendiculaire à la ligne médiane avec l'un des pôles au-dessus de la ligne médiane et l'autre des pôles au-dessous de la ligne médiane.

Le deuxième compartiment auxiliaire 104 comprend une face de branchement 160 s'étendant parallèlement à la direction d'introduction P', face au circuit imprimé 118. Une première plage conductrice 161 et une deuxième plage conductrice 162 disposées de part et d'autre d'une ligne médiane 163 de la face de branchement 160 débouchent sur la face de branchement 160. Une plage conductrice centrale 164 située sur la ligne médiane 163 débouche également sur la face de branchement 160. Les plages conductrices 161, 162 et 164 sont oblongues et s'étendent selon une direction parallèle à la ligne médiane 163. La première plage conductrice 161 est reliée à une première piste du circuit imprimé 118 et constitue un pôle positif d'une alimentation électrique 165, la deuxième plage conductrice 162 est quant à elle reliée à une deuxième piste du circuit imprimé 118 et constitue un pôle négatif d'une alimentation électrique 165. La piste conductrice centrale 164 constitue une masse de l'alimentation électrique 165. Des coupleurs magnétiques 166.1 à 166.12 débouchent également sur la face de branchement 160. Une première série de coupleurs magnétiques comprend des coupleurs magnétiques 166.1 à 166.6 qui s'étendent symétriquement de part et d'autre de la ligne médiane 163 à proximité d'une première ouverture 108 du compartiment 104. Une deuxième série de coupleurs magnétiques comprend des coupleurs magnétiques 166.7 à 166.12 qui s'étendent symétriquement de part et d'autre de la ligne médiane 163 à proximité d'une deuxième ouverture 108 du compartiment 104 opposée à la première ouverture 108. Des coupleurs optiques 167.1 à 167.4 débouchent eux aussi sur la face de branchement 160. Une première série de coupleurs optiques comprend les coupleurs optiques 167.1 et 167.2 qui s'étendent symétriquement de part et d'autre de la ligne médiane 163 à proximité d'une première ouverture 108 du compartiment 104. Une deuxième série de coupleurs optiques comprend des coupleurs optiques 167.3 et 167.4 qui s'étendent symétriquement de part et d'autre de la ligne médiane 163 à proximité d'une deuxième ouverture 108 du compartiment 104 opposée à la première ouverture 108. La première série de coupleurs optiques 167.1 et 167.2 et la première série de coupleurs magnétiques 166.1 à 166.6 sont respectivement symétriques à la deuxième série de coupleurs optiques 167.3 et 167.4 et la deuxième série de coupleurs magnétiques 166.7 à 166.12 par rapport à un plan médian de la face 160 orthogonal à la direction médiane 163.

Les coupleurs magnétiques 166.1 à 166.12 et optiques 167.1 à 167.4 sont reliés au circuit imprimé 118. La face de branchement 160 est recouverte d'une fine couche 168 de PTFE et la face 169 opposée à la face de branchement 160 comprend trois ressorts 170.1 à 170.3 longitudinaux s'étendant parallèlement à ligne médiane 163. Le circuit imprimé 118 est raccordé, d'une part, aux modules de calcul 122 comme cela a été mentionné plus haut et, d'autre part, à un connecteur 119 porté par la paroi de fond 116 et relié à des câbles de puissance et de commande du faisceau électrique 9.

Le module 124 est ici de forme sensiblement parallélépipédique et comprend deux extrémités d'introduction respectivement 125 et 126 du module 124 dans le compartiment 104 selon deux sens opposés de la direction d'introduction P'. Le module 124 comprend également une face de branchement 127 au boitier 100 sur laquelle débouchent un premier et un deuxième contact flexible respectivement, 171 et 172, disposés de part et d'autre d'une ligne médiane 173 de la face de branchement 127. Un troisième contact flexible central 174 situé sur la ligne médiane 173 débouche également sur la face de branchement 127. Comme visible sur la figure 7, les contacts flexibles 171, 172 et 174 s'étendent selon une direction parallèle à la ligne médiane 173 et la face de branchement 127 s'étend parallèlement à la direction d'introduction P'. Des coupleurs magnétiques 175.1 à 175.12 débouchent également sur la face de branchement 127. Une première série de coupleurs magnétiques comprend des coupleurs magnétiques 175.1 à 175.6 qui s'étendent symétriquement de part et d'autre de la ligne médiane 173 à proximité de l'extrémité d'introduction 125. Une deuxième série de coupleurs magnétiques comprend des coupleurs magnétiques 175.7 à 175.12 qui s'étendent symétriquement de part et d'autre de la ligne médiane 173 à proximité de l'extrémité d'introduction 126. Des coupleurs optiques 176.1 à 176.4 débouchent eux aussi sur la face de branchement 127 et s'étendent symétriquement de part et d'autre de la ligne médiane 173. Une première série de coupleurs optiques comprend des coupleurs optiques 176.1 et 176.2 qui s'étendent symétriquement de part et d'autre de la ligne médiane 173 à proximité de l'extrémité d'introduction 125. Une deuxième série de coupleurs optiques comprend des coupleurs optiques 176.3 et 176.4 qui s'étendent symétriquement de part et d'autre de la ligne médiane 173 à proximité de l'extrémité d'introduction 126. La première série de coupleurs optiques 176.1 et 176.2 et la première série de coupleurs magnétiques 175.1 à 175.6 sont respectivement symétriques à la deuxième série de coupleurs optiques 176.3 et 176.4 et la deuxième série de coupleurs magnétiques 175.7 à 175.12 par rapport à un plan médian de la face 127 orthogonal à la direction médiane 173.La face de branchement 127 est recouverte d'une fine couche 177 de PTFE.

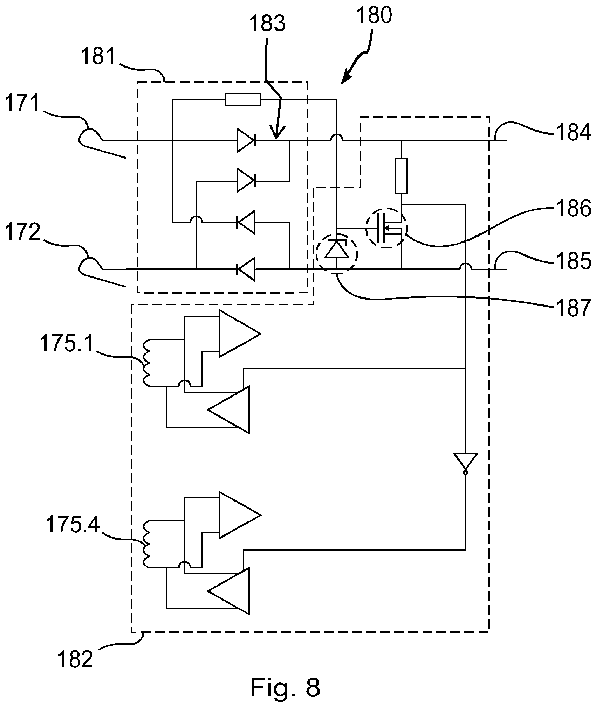

Les contacts flexibles 171 et 172, les coupleurs magnétiques 175.1 à 175.12 et optiques 176.1 à 176.4 sont reliés à un circuit électronique 180 qui comprend un premier circuit 181 et un deuxième circuit 182. Pour des raisons de clarté, seuls deux coupleurs magnétiques 175.1 et 175.4 sur l'ensemble des coupleurs magnétiques 175.1 à 175.6 et optiques 176.1 et 176.2 seront représentés sur le schéma de la figure 8. Les contacts flexibles 171 et 172 sont reliés aux bornes d'entrée d'un premier circuit 181 qui comprend un pont de diode 183. Ce premier circuit 181 permet de restituer une polarité d'alimentation constante entre ses bornes de sortie 184 et 185 quelle que soit la polarité de la tension appliquée entre les contacts flexibles 171 et 172. Le deuxième circuit 182 est relié aux coupleurs magnétiques 175.1 et 175.4 qui sont ici des émetteurs/récepteurs dont la partie émission est mise en basse impédance en fonction de la polarité de la tension appliquée entre les contacts flexibles 171 et 172. Cette mise en basse impédance est effectuée par un transistor MOS 186 dont la grille est soumise à la tension appliquée entre les contacts flexibles 171 et 172. Une diode Zener 187 protège l'entrée du transistor MOS 186 des surtensions. Ainsi, le deuxième circuit 182 permet de modifier le sens de communication des coupleurs 175.1 et 175.4 en fonction de la polarité de la tension appliquée entre les contacts flexibles 171 et 172. Le deuxième circuit 182 étant relié de la même façon aux autres coupleurs magnétiques et optiques, il permet donc, de la même façon, de modifier le sens de communication des coupleurs magnétiques 175.1 à 175.12 et optiques 176.1 à 176.4 en fonction de la polarité de la tension appliquée entre les contacts flexibles 171 et 172.

Le module 123 comporte lui également une face de branchement 527 au boitier 100 sur laquelle débouchent un premier contact flexible 571 et un deuxième contact flexible 572, disposés de part et d'autre d'une ligne médiane 573 de la face de branchement 527. Un troisième contact flexible central 574 situé sur la ligne médiane 573 débouche également sur la face de branchement 527. Comme visible sur la figure 9, les contacts flexibles 571, 572 et 574 s'étendent selon une direction parallèle à la ligne médiane 573 et la face de branchement 527 s'étend parallèlement à la direction d'introduction P. La face de branchement 527 peut comprendre des connecteurs aérauliques (non représentés) reliés au ventilateur 140 du module 123 et des connecteurs électriques pour la surveillance de fonctionnement.

En référence à la figure 10, la mise en place de quatre modules communs 124, 224, 324, 424 identiques respectivement dans quatre unités de calcul 100, 200, 300 et 400 d'un fuselage 1 d'un aéronef va être décrite. Les éléments identiques ou analogues à ceux du module commun 124 comporteront une référence numérique augmentée respectivement d'une centaine, de deux centaines et de trois centaines pour respectivement désigner les éléments des modules communs 224, 324 et 424. Les éléments identiques ou analogues à ceux de l'unité de calcul 100 comporteront une référence numérique augmentée respectivement d'une centaine, de deux centaines et de trois centaines pour respectivement désigner les éléments des unités de calcul 200, 300 et 400.

Les unités de calcul 100 et 200 sont respectivement situées à droite et à gauche d'une direction longitudinale L du fuselage 1 et ont leurs ouvertures frontales respectives 105 et 205 débouchant vers l'avant du fuselage 1. Les unités de calcul 300 et 400 sont, quant à elles, respectivement situées à droite et à gauche d'une direction longitudinale L du fuselage 1 et ont leurs ouvertures frontales respectives 305 et 405 débouchant vers l'arrière du fuselage 1.

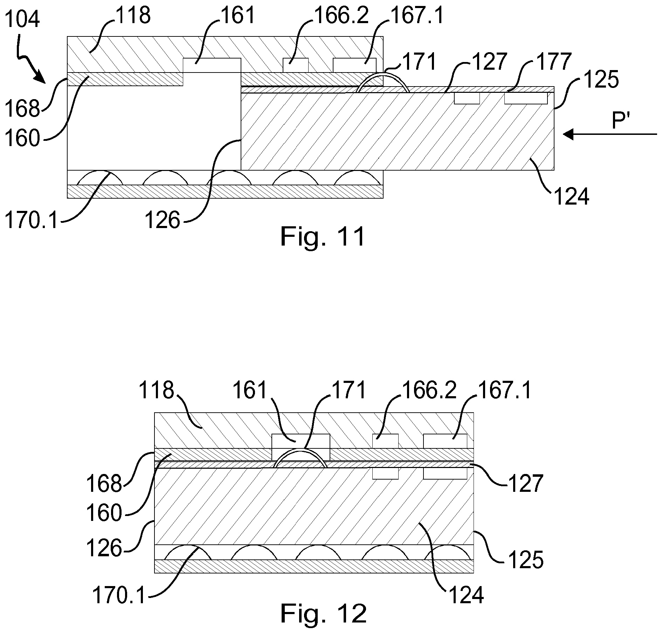

Le montage du module commun 124 dans le compartiment 104 de l'unité 100 se fait en introduisant l'extrémité d'introduction 126 du module commun 124 dans l'ouverture latérale 108 orientée vers la zone médiane 7 du compartiment 104 selon une direction d'introduction P' perpendiculaire à la direction longitudinale L, la face de branchement 127 étant orientée vers l'avant du fuselage 1. Lors de la translation du module commun 123 dans le compartiment 104, les couches de PTFE 168 et 177 respectives des faces de branchement 160 et 127 sont mises en contact sous l'effet des ressorts longitudinaux 170.1 à 170.3 et glissent l'une contre l'autre. Comme visible en figure 11, les contacts flexibles 171, 172 et 174 sont repoussés par la face de branchement 160 lors de leur entrée dans le deuxième compartiment auxiliaire 104 et glissent contre la couche de PTFE 168 de la face de branchement 160 jusqu'à ce qu'ils se trouvent respectivement face aux plages conductrices 161, 162 et 164. Dans cette position, les coupleurs optiques 176.1 à 176.4 ainsi que les coupleurs magnétiques 175.1 à 175.12 de la face de branchement 127 du module commun 124 font respectivement face aux coupleurs optiques 167.1 à 167.4 et aux coupleurs magnétiques 166.1 à 166.12 de la face de branchement 160 du deuxième compartiment auxiliaire 104. Les couches 168 et 177 garantissent également une distance maitrisée entre les faces de branchement 160 et 127. Le pôle positif constitué par la première plage conductrice 161 de l'alimentation électrique 165 du deuxième compartiment auxiliaire 104 est en contact électrique avec le contact flexible 171 du module commun 124. Le pôle négatif constitué par la deuxième plage conductrice 162 de l'alimentation électrique 165 du deuxième compartiment auxiliaire 104 est, quant à lui, en contact électrique avec le contact flexible 172 du module commun 124. Ainsi, le premier circuit 181 reçoit une tension U₁₇₁₋₁₇₂, mesurée entre les premier et deuxième contacts flexibles 171 et 172, positive. Le deuxième circuit 182 passe alors les coupleurs magnétiques 175.1 à 175.3 et 175.7 à 175.9 ainsi que les coupleurs optiques 176.1 et 176.3 en mode « émission » et les coupleurs magnétiques 175.4 à 175.6, 175.9 à 175.12 et les coupleurs optique 176.2 et 176.4 en mode « réception ». La dépose du module commun 124 hors du deuxième compartiment auxiliaire 104 se fait en saisissant l'extrémité 125 du module commun 124 afin de le faire translater selon la direction P'. Au cours de cette translation, les contacts flexibles 171, 172 et 174 sont repoussés par la face de branchement 160 et glissent contre la couche de PTFE 168 de la face de branchement 160 jusqu'à l'extraction complète du module commun 124 hors du deuxième compartiment auxiliaire 104.

Le montage du module commun 224 dans le compartiment 204 de l'unité 200 se fait en introduisant l'extrémité d'introduction 225 du module commun 224 dans l'ouverture latérale 208 orientée vers la zone médiane 7 du deuxième compartiment auxiliaire 204 selon une direction d'introduction P' perpendiculaire à la direction longitudinale L, la face de branchement 227 étant orientée vers l'avant du fuselage 1. Dans cette position, les coupleurs optiques 276.1 à 276.4 ainsi que les coupleurs magnétiques 276.1 à 276.12 de la face de branchement 227 du module commun 224 font respectivement face aux coupleurs optiques 267.1 à 267.4 et aux coupleurs magnétiques 266.1 à 266.12 de la face de branchement 260 du deuxième compartiment auxiliaire 204. Le pôle positif constitué par la première plage conductrice 261 de l'alimentation électrique 265 du deuxième compartiment auxiliaire 204 est en contact électrique avec le contact flexible 271 du module commun 224. Le pôle négatif constitué par la deuxième plage conductrice 262 de l'alimentation électrique 265 du deuxième compartiment auxiliaire 204 est, quant à lui, en contact électrique avec le contact flexible 272 du module commun 224. Ainsi, le premier circuit 281 reçoit une tension U₂₇₁₋₂₇₂, mesurée entre les premier et deuxième contacts flexibles 271 et 272, positive. Le deuxième circuit 282 passe alors les coupleurs magnétiques 275.1 à 275.3 et 275.7 à 275.9 ainsi que les coupleurs optiques 276.1 et 276.3 en mode « émission » et les coupleurs magnétiques 275.4 à 275.6, 275.10 à 275.12 et les coupleurs optiques 276.2 et 276.4 en mode « réception ».

Le montage du module commun 324 dans le compartiment 304 de l'unité 300 se fait en introduisant l'extrémité d'introduction 326 du module commun 324 dans l'ouverture latérale 308 orientée vers la zone médiane 7 du deuxième compartiment auxiliaire 304 selon une direction d'introduction P' perpendiculaire à la direction longitudinale L, la face de branchement 327 étant orientée vers l'arrière du fuselage 1. Dans cette position, les coupleurs optiques 376.1, 376.2, 376.3, 376.4 ainsi que les coupleurs magnétiques 375.1 à 375.6 et 375.7 à 375.12 de la face de branchement 327 du module commun 324 font respectivement face aux coupleurs optiques 367.4, 367.3, 367.2 et 367.1 et aux coupleurs magnétiques 366.12 à 366.7 et 366.6 à 366.1 de la face de branchement 360 du deuxième compartiment auxiliaire 304. Le pôle positif constitué par la première plage conductrice 361 de l'alimentation électrique 365 du deuxième compartiment auxiliaire 304 est en contact électrique avec le contact flexible 372 du module commun 324. Le pôle négatif constitué par la deuxième plage conductrice 362 de l'alimentation électrique 365 du deuxième compartiment auxiliaire 304 est, quant à lui, en contact électrique avec le contact flexible 372 du module commun 324. Ainsi, le premier circuit 381 reçoit une tension U₃₇₁₋₃₇₂, mesurée entre les premier et deuxième contacts flexibles 371 et 372, négative. Le deuxième circuit 382 passe alors les coupleurs magnétiques 375.1 à 375.3, 375.7 à 375.9 et les coupleurs optiques 376.1 et 376.3 en mode « réception »et les coupleurs magnétiques 375.4 à 375.6, 375.10 à 375.12 et les coupleurs optiques 376.2 et 376.4 en mode « émission ».

Le montage du module commun 424 dans le compartiment 404 de l'unité 400 se fait en introduisant l'extrémité d'introduction 425 du module commun 424 dans l'ouverture latérale 408 orientée vers la zone médiane 7 du deuxième compartiment auxiliaire 404 selon une direction d'introduction P' perpendiculaire à la direction longitudinale L, la face de branchement 427 étant orientée vers l'arrière du fuselage 1. Dans cette position, les coupleurs optiques 476.1, 476.2, 476.3, 476.4 ainsi que les coupleurs magnétiques 475.1 à 475.6 et 475.7 à 475.12 de la face de branchement 427 du module commun 424 font respectivement face aux coupleurs optiques 467.4, 467.3, 467.2, 467.1 et aux coupleurs magnétiques 466.12 à 466.7 et 466.6 à 466.1 de la face de branchement 460 du deuxième compartiment auxiliaire 404. Le pôle positif constitué par la première plage conductrice 461 de l'alimentation électrique 465 du deuxième compartiment auxiliaire 404 est en contact électrique avec le contact flexible 472 du module commun 424. Le pôle négatif constitué par la deuxième plage conductrice 462 de l'alimentation électrique 465 du deuxième compartiment auxiliaire 404 est, quant à lui, en contact électrique avec le contact flexible 472 du module commun 424. Ainsi, le premier circuit 481 reçoit une tension U₄₇₁₋₄₇₂, mesurée entre les premier et deuxième contacts flexibles 471 et 472, négative. Le deuxième circuit 482 passe alors les coupleurs magnétiques 475.1, 475.2, 475.3 et le coupleur optique 476.1 en mode « réception »et les coupleurs magnétiques 475.4, 475.5, 475.6 et 476.2 en mode « émission ».

On comprend que l'agencement décrit plus haut des contacts flexibles permet d'utiliser des modules communs 124, 224, 324, 424 identiques dans les unités de calcul 100, 200, 300 et 400 puisqu'il suffit de renverser le module commun autour de son axe longitudinal pour que les contacts électriques se trouvent soit à gauche soit à droite.

On obtient alors un unique modèle d'unité de calcul coopérant avec un unique type de module et pouvant être monté dans quatre configurations différentes sans modifications. Les coûts de certification, de production, de maintenance et d'installation sont ainsi fortement réduits.

Les éléments identiques ou analogues à ceux de l'unité de calcul 100 comporteront une référence numérique augmentée respectivement de quatre centaines dans la description qui suit d'un mode de réalisation particulier d'une unité de calcul selon l'invention.

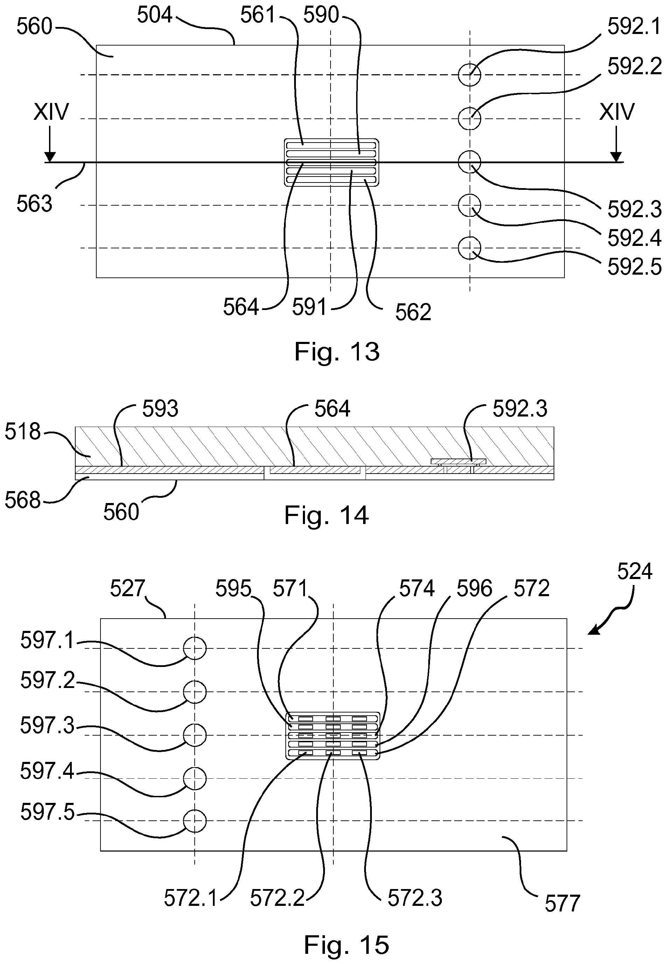

En référence à la figure 13, la face de branchement 560 du deuxième logement auxiliaire 504 comprend cinq pistes conductrices 561, 562, 564, 590 et 591. La première plage conductrice 561 est reliée à une première piste du circuit imprimé 518 et constitue un pôle positif d'une alimentation électrique 565, la deuxième plage conductrice 562 est quant à elle reliée à une deuxième piste du circuit imprimé 518 et constitue un pôle négatif d'une alimentation électrique 565. La piste conductrice centrale 564 constitue une masse de l'alimentation électrique 565. Les pistes supplémentaires 590 et 591 qui s'étendent symétriquement par rapport à ligne médiane 563 sont respectivement des ports d'entrée et de sortie de communication. Des coupleurs magnétiques 592.1 à 592.5 débouchent également sur la face de branchement 560. Ces coupleurs magnétiques s'étendent symétriquement de part et d'autre de la ligne médiane 563 à proximité d'une première ouverture 508 du compartiment 504.

Comme visible en figure 14, le circuit imprimé 518 comprend une plaque métallique 593 s'étendant sur toute la surface de branchement 560 et sur laquelle sont fixée les plages conductrices 561, 562, 564, 590, 591 ainsi que les enroulements des coupleurs magnétiques 592.1 à 592.5. La couche de PTFE 568 recouvre la plaque 593 et comprend une réservation à l'aplomb des plages conductrices 561, 562, 564, 590, 591. Le circuit imprimé 518 comprend également des cylindres 594.1 à 594.5 de blindage des coupleurs magnétiques 592.1 à 592.5 s'étendant à proximité de la face de la plaque 593 opposée à la couche 568.

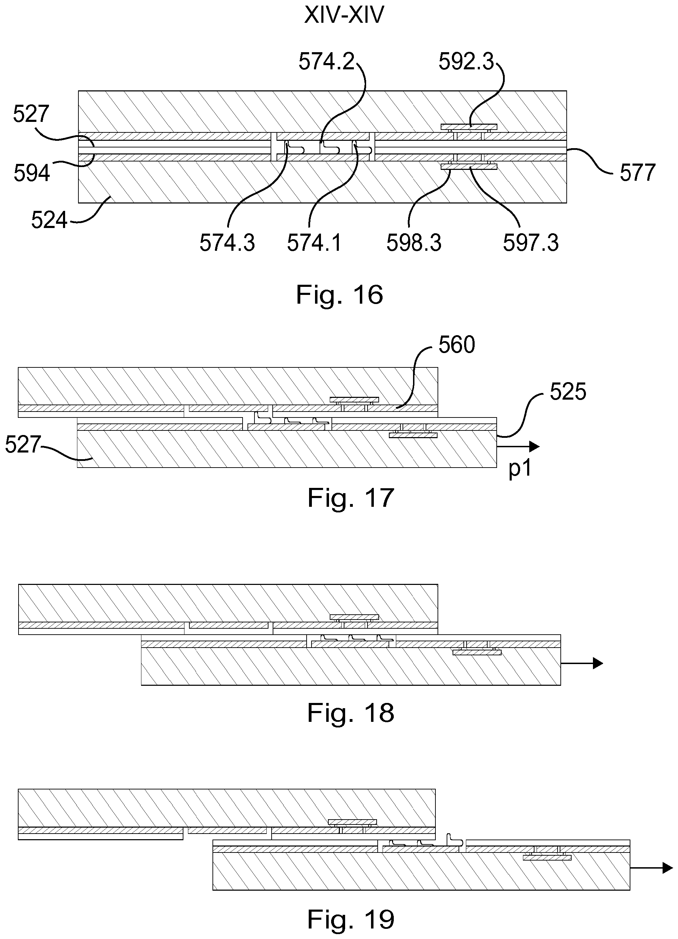

Comme visible aux figures 15 et 16, la face de branchement 527 du module commun 524 comprend également une plaque métallique 594 s'étendant sur toute la surface de branchement 560 et sur laquelle sont fixée des contacts flexibles 571, 572, 574, 595, 596 ainsi que des enroulements des coupleurs magnétiques 597.1 à 597.5. Les contacts flexibles 571, 572, 574, 595, 596 comprennent respectivement trois pontets élastiques 571.1 à 571.3, 572.1 à 572.3, 574.1 à 574.3, 595.1 à 595.3, 596.1 à 596.3. La couche de PTFE 577 recouvre la plaque 594 et comprend une réservation à l'aplomb des plages conductrices 571, 572, 574, 595, 596. La face de branchement 560 comprend également des cylindres 598.1 à 594.5 de blindage des coupleurs magnétiques 592.1 à 592.5 s'étendant à proximité de la face de la plaque 593 opposée à la couche 568.

Lorsque le module commun 524 est en place dans le deuxième logement auxiliaire 504 (figure 16), les coupleurs magnétiques 597.1 à 597.5 du module commun 524 font face aux coupleurs magnétiques 592.1 à 592.5 de l'unité de calcul 500, assurant ainsi le couplage magnétique de l'unité 500 et du module 524. Les pontets élastiques des contacts flexibles 571, 572, 574, 595 et 596 viennent respectivement au contact des plages conductrices 561, 562, 564, 590 et 591, assurant l'alimentation du module commun 524 par l'alimentation 565 et la mise en communication du module commun 524 avec l'unité de calcul 500. Les plaques métalliques 593 et 594 en regard assurent un efficace couplage capacitif entre le module commun 524 et l'unité de calcul 500.

La dépose du module commun 524 hors du deuxième compartiment auxiliaire 504 se fait en saisissant l'extrémité 525 du module commun 524 afin de le faire translater selon la direction P'. Au cours de cette translation, les pontets des contacts flexibles 571, 572 et 574 sont repoussés par la face de branchement 560 et glissent contre la couche de PTFE 568 de la face de branchement 560 jusqu'à l'extraction complète du module commun 524 hors du deuxième compartiment auxiliaire 104 (figures 17 à 19.

Les unités de calcul 100 sont disposées dans au moins l'un des logements latéraux 6 de telle manière que la direction d'insertion I soit sensiblement parallèle à la direction longitudinale L du fuselage 1. On notera que le retrait du panneau 109 permet d'accéder directement au module de calcul 122 le plus proche de la zone médiane 7.

Plus précisément, les unités de calcul 100 sont montées par paires en des positions adjacentes dans les logements latéraux 6 de telle manière que les parois de fond 116 des boîtiers 101 s'étendent en regard l'une de l'autre. Des câbles 8 du faisceau électrique 9 sont amenés entre les deux unités de calcul 100 pour être connectés à celles-ci via les connecteurs 115 et 119, ce qui facilite le raccordement des unités de calcul 100 au faisceau électrique 9.

On comprend que l'agencement décrit plus haut des contacts flexibles permet d'utiliser des modules communs 123 et 124 identiques dans les deux unités de calcul 100 puisqu'il suffit de renverser le module commun autour de son axe longitudinal et de la direction d'insertion pour que les contacts électriques se trouvent soit à gauche soit à droite.

Le module commun 123 va maintenant être détaillé. Un conduit 11, s'étendant entre le fuselage 1 et l'unité de calcul 100, relie la conduite principale 10 la plus proche à une prise d'air monté sur le panneau 110 pour déboucher en regard d'une ouverture du module commun 113 en regard de laquelle est monté un premier clapet anti-retour 130.1 agencé pour autoriser un passage de l'air de refroidissement du conduit 11 jusque dans le module commun 123 et s'opposer à une circulation d'air en sens opposé. Le module commun 123 comprend une prise d'air extérieur 120 qui débouche dans la zone centrale 7 et qui est associée à un ventilateur 140 d'introduction d'air dans le module commun 123 et à un deuxième clapet anti-retour 130.2 agencé pour autoriser un passage d'air depuis le ventilateur 140 jusque dans le module commun 123 et s'opposer à une circulation d'air en sens opposé. Le module commun 123 a une paroi supérieure pourvue d'ouvertures d'évacuation d'air vers le compartiment principal 102.

Les clapets 130.1 et 130.2 sont similaires l'un à l'autre et comprennent ici un corps 131, creux, fixé à une des parois latérales du module commun 123 et raccordé de manière étanche au conduit 11 pour le clapet 130.1 et à la sortie du ventilateur 140 pour le clapet 130.2. Le corps 131 est pourvu d'une pluralité d'ouvertures en regard de chacune desquelles est monté un volet 132 ayant un bord libre et à l'opposé un bord articulé au corps 131 de telle manière que le volet 132 pivote entre une position fermée et une position ouverte. Les volets 132 sont ainsi positionnés de telle manière que les volets 132 puissent être soulevés par un flux d'air allant en direction de l'intérieur du module commun 123 de manière à laisser passer ce flux d'air mais soient plaqués en position fermée par tout flux d'air ayant une direction opposée. Le moyen de rappel est par exemple un ressort taré pour autoriser le soulèvement des volets 132 par le flux d'air entrant dans le module commun 123 sans occasionner une perte de charge dans le flux d'air empêchant celui-ci de parcourir le module commun 123 et le compartiment principal 102. En variante, le moyen de rappel peut être la gravité. On comprend que :
- lorsque le système de soufflage d'air de l'aéronef est en fonctionnement, le clapet anti-retour 130.1 laisse passer l'air tandis que le ventilateur 140 est arrêté et que le clapet anti-retour 130.2 empêche le passage de l'air provenant du clapet anti-retour 130.1 ;
- lorsque le système de soufflage d'air de l'aéronef est défaillant, le ventilateur 140 est mis en fonctionnement pour souffler de l'air que le clapet anti-retour 130.2 laisse passer tandis que le clapet anti-retour 130.1 empêche le passage de l'air provenant du clapet anti-retour 130.2. La mise en action du ventilateur 140 est commandée via le faisceau électrique 9 après détection de la défaillance du système de soufflage d'air de l'aéronef.

Le ventilateur 140 comprend ici une roue à aubes 141 entraînée, par un moteur électrique non représenté, en rotation dans un carter 142. Le carter 142 comprend deux parois 143 perpendiculaires à l'axe de rotation de la roue à aubes 141 réunies par une paroi périphérique circulaire 144 entourant la roue à aubes 141 qui s'étend entre les parois 143. L'une des parois 143 est fixée à la paroi du module commun 123 et l'autre des parois 143 est pourvu d'orifices 145 d'échappement d'air au voisinage de la paroi périphérique circulaire 144 tout en étant écartés de la paroi périphérique circulaire 144. La paroi périphérique circulaire 144 s'étend autour de la roue à aubes 141 et ayant une partie inférieure prolongée tangentiellement par un couloir tangentiel vertical 146 auquel est fixé un réceptacle 147. La roue à aubes 141 comprend un moyeu creux formant un conduit en communication avec la prise d'air 120 de telle manière que la rotation de la roue à aubes 141 tende à entraîner l'air provenant de la prise d'air 120 vers les orifices 145 du carter 142. Les poussières qui pourraient se trouver dans le flux d'air sont entraînées par un effet de centrifugation contre la paroi périphérique circulaire 144 jusque dans le couloir tangentiel vertical 146 et le réceptacle 147 où les poussières seront piégées. Le nettoyage du réceptacle 147 permet de retirer les poussières.

Bien entendu, l'invention n'est pas limitée aux modes de réalisation décrits mais englobe toute variante entrant dans le champ de l'invention telle que définie par les revendications.

En particulier, le boîtier de l'unité de calcul 100 peut avoir une autre forme et comprendre un nombre différent de compartiment auxiliaire ou pas de compartiment auxiliaire du tout.

Bien qu'ici le module décrit soit un module commun aux modules de calcul, l'invention s'applique également à d'autres types de module électronique comme par exemple des modules de ventilation ou des modules dédiés une partie des modules de calcul ou à un seul de ceux-ci.

Bien qu'ici l'alimentation du module électronique se fasse à l'aide de plages conductrices oblongues, l'invention s'applique également à d'autres moyens d'alimentation électrique du module électronique comme par exemple des plages conductrices circulaires ou des connecteurs sans contact inductifs.

Bien qu'ici les faces de branchement du module électronique et du deuxième compartiment auxiliaire comprennent un revêtement en PTFE, l'invention s'applique également à d'autres types de revêtement réduisant les frottements comme par exemple du PCTFE, FE, MFA ou d'autres polymères. L'invention s'applique également à une seule face de branchement -du module électronique ou de l'unité de calcul- qui soit pourvue d'un revêtement réduisant les frottements. Le revêtement pouvant s'étendre sur toute la face de branchement ou seulement sur une partie de celle-ci.

Bien qu'ici le deuxième compartiment auxiliaire comporte trois ressorts longitudinaux, l'invention s'applique également à d'autres types d'éléments élastiques agencés pour exercer un effort de mise en contact contre la face de branchement comme par exemple un unique ressort longitudinal, des lames en caoutchouc ou des ressorts hélicoïdaux.

Bien qu'ici le module commun soit de forme sensiblement parallélépipédique, l'invention s'applique également à des modules de forme différente comme par exemple de modules triangulaires ou cylindriques droits.

Bien qu'ici le module électronique comprenne des contacts flexibles, l'invention s'applique également à d'autres moyens de liaison à une alimentation électrique comme par exemple des plots électriques fixes, des connecteurs sans contact inductifs ou des balais conducteurs.

Bien qu'ici le module électronique, tout comme l'unité de calcul, comprenne des coupleurs optiques et des coupleurs magnétiques, l'invention s'applique également à d'autres moyens de connexion comme par exemple des plages conductrices ou des émetteurs récepteurs radio ou micro-ondes. Les connecteurs magnétiques et/ou optiques sont préférés car ils permettent un découplage électrique du module électronique et de l'unité de calcul.

Bien qu'ici les moyens de connexion soient répartis symétriquement par rapport à un axe médian et un plan orthogonal à cet axe, l'invention s'applique également à des moyens de connexion répartis différemment, il est alors requis d'également renverser le module commun autour d'un axe perpendiculaire à sa direction d'introduction. Dans ce cas particulier, l'insertion du module commun dans le compartiment se fait toujours par la même extrémité d'introduction. Bien qu'ici l'unité soit une unité de calcul, l'invention s'applique également à d'autres types d'unité électroniques comme par exemple une unité de communication, de climatisation ou autre.

En variante, le module commun est agencé pour assurer une seule fonction transversale et par exemple une alimentation en énergie des modules de calcul, un refroidissement des modules de calcul ou une interconnexion des modules de calcul.

En variante, on peut utiliser des modules communs destinés à n'être utilisés que dans une seule position soit ayant des contacts flexibles à droite, soit avec des contacts flexibles à gauche. En variante encore, les modules communs ont un fond équipé d'un connecteur et le boîtier de l'unité de calcul peut être équipé d'un connecteur homologue déplaçable pour être monté sur le panneau de fond des compartiments auxiliaires, quel que soit le sens de montage de l'unité de calcul dans le logement latéral.

En variante, d'autres moyens de ventilation peuvent être utilisés et par exemple un ventilateur disposé derrière un filtre chargé d'empêcher l'introduction de poussière dans le module commun de refroidissement.

L'invention n'est pas limitée à une application dans le domaine de l'aéronautique.

## Revendications

1. Unité électronique (100, 200, 300, 400) comprenant un boîtier (101) délimitant un compartiment (104, 204, 304, 404) de réception d'un module électronique (124, 224, 324, 424) selon deux sens opposés l'un à l'autre d'une direction d'introduction (P'), le compartiment comprenant des moyens d'alimentation électrique (165, 265, 365, 465) du module électronique (124, 224, 324, 424) et des moyens de connexion (166.1-166.12, 167.1-167.4) de l'unité électronique (100, 200, 300, 400) au module électronique (124, 224, 324, 424), ces moyens débouchant sur une face de branchement (160) appartenant au compartiment de réception (104, 204, 304, 404) s'étendant parallèlement à la direction d'introduction (P').

2. Unité électronique (100, 200, 300, 400) selon la revendication 1, dans lequel les moyens d'alimentation (165, 265, 365, 465) comprennent une première plage conductrice (161, 261, 361, 461) et une deuxième plage conductrice (162, 262, 362, 462) disposées de part et d'autre d'une ligne médiane (163) de la face de branchement(160, 260, 360, 460), une des première et deuxième plages conductrices(161, 261, 361, 461) étant le pôle positif de l'alimentation électrique du module électronique, l'autre des première et deuxième plages conductrices (162, 262, 362, 462) étant le pôle négatif de l'alimentation électrique du module électronique.

3. Unité électronique (100, 200, 300, 400) selon la revendication 2, dans lequel les plages conductrices (161, 261, 361, 461, 162, 262, 362, 462) s'étendent selon une direction parallèle à la ligne médiane (163).

4. Unité électronique (100, 200, 300, 400) selon l'une quelconque des revendications précédentes, dans lequel la face de branchement (160, 260, 360, 460) comprend au moins partiellement un revêtement réduisant les frottements (168).

5. Unité électronique (100, 200, 300, 400) selon l'une quelconque des revendications précédentes, dans lequel les moyens de connexion (166.1-166.12, 167.1-167.4) du module électronique à l'unité électronique comprennent au moins un coupleur magnétique (166.1-166.12).

6. Unité électronique (100, 200, 300, 400) selon l'une quelconque des revendications précédentes, dans lequel les moyens de connexion 166.1-166.12, 167.1-167.4) du module électronique à l'unité électronique comprennent au moins un coupleur optique (167.1-167.4).

7. Unité électronique (100, 200, 300, 400) selon l'une quelconque des revendications précédentes, dans lequel une face du compartiment opposée à la face de branchement comprend au moins un élément élastique (170.1-170.3) agencé pour exercer un effort de mise en contact contre la face de branchement (160, 260, 360, 460).

8. Module électronique (124, 224, 324, 424) comprenant au moins une extrémité d'introduction (125, 126, 225, 226, 325, 326, 425, 426) dans un compartiment (104, 204, 304, 404) d'une unité électronique (100, 200, 300, 400) selon deux sens opposés d'une direction d'introduction (P'), des moyens de liaison (171, 172, 271, 272, 371, 372, 471, 472) à une alimentation électrique (165, 265, 365, 465) et des moyens de connexion (175.1-175.12, 176.1-176.4) à l'unité électronique (100, 200, 300, 400), les moyens de liaison à une alimentation électrique (165, 265, 365, 465) et les moyens de connexion (175.1-175.12, 176.1-176.4) à l'unité électronique (100, 200, 300, 400) débouchant sur une face de branchement (127, 227, 327, 427) appartenant au module électronique (124, 224, 324, 424) , la face de branchement (127, 227, 327, 427)s'étendant parallèlement à la direction d'introduction (P').

9. Module électronique (124, 224, 324, 424) selon la revendication 8, dans lequel les moyens de liaison à une alimentation électrique (165, 265, 365, 465) comprennent un premier contact flexible (171, 271, 371, 471)et un deuxième contact flexible (172, 272, 372, 472)disposés de part et d'autre d'une ligne médiane (173) de la face de branchement (127, 227, 327, 427) à l'unité électronique (100, 200, 300, 400).

10. Module électronique (124, 224, 324, 424) selon la revendication 9, dans lequel les contacts flexibles (171, 172, 271, 272, 371, 372, 471, 472) s'étendent selon une direction parallèle à la ligne médiane (173).

11. Module électronique (124, 224, 324, 424) selon l'une quelconque des revendications 8 à 10, dans lequel les moyens de liaison (171, 172, 271, 272, 371, 372, 471, 472) à une alimentation électrique comprennent des moyens (181, 281, 381, 481) pour restituer une polarité d'alimentation constante quelle que soit la polarité de la tension appliquée aux moyens de liaison (171, 172, 271, 272, 371, 372, 471, 472) à une alimentation électrique (165, 265, 365, 465).

12. Module électronique (124, 224, 324, 424) selon l'une quelconque des revendications 8 à 11, comprenant des moyens (182, 282, 382, 482) reliés aux moyens de liaison (171, 172, 271, 272, 371, 372, 471, 472) à une alimentation électrique (165, 265, 365, 465)et conformés pour modifier un sens de communication des moyens de connexion (175.1-175.12, 176.1-176.4) à l'unité électronique (100, 200, 300, 400).

13. Module électronique (124, 224, 324, 424) selon l'une quelconque des revendications 8 à 12, dans lequel les moyens de connexion (175.1-175.12, 176.1-176.4) à l'unité électronique (100, 200, 300, 400) comprennent un coupleur magnétique (175.1-175.12).

14. Module électronique (124, 224, 324, 424) selon l'une quelconque des revendications 8 à 12, dans lequel les moyens de connexion (175.1-175.12, 176.1-176.4) à l'unité électronique (100, 200, 300, 400) comprennent un coupleur optique (176.1-176.4).

15. Aéronef comprenant un fuselage contenant au moins une unité électronique selon l'une quelconque des revendications 1 à 7.

16. Aéronef selon la revendication 15, comprenant plusieurs unités électroniques réparties dans le fuselage, le fuselage étant divisé par un plancher en un volume supérieur et un volume inférieur dans lequel s'étendent des poutrelles supportant le plancher et délimitant avec le fuselage et le plancher deux logements latéraux qui ont une section transversale sensiblement triangulaire et qui s'étendent parallèlement à une direction longitudinale du fuselage, les unités électroniques étant disposées dans au moins l'un des logements latéraux.

## Patentansprüche

1. Elektronische Einheit (100, 200, 300, 400), umfassend ein Gehäuse (101), das ein Fach (104, 204, 304, 404) zur Aufnahme eines elektronischen Moduls (124, 224, 324, 424) in zwei zueinander entgegengesetzte Richtungen einer Einführrichtung (P') begrenzt, wobei das Fach Stromversorgungsmittel (165, 265, 365, 465) zur Stromversorgung des elektronischen Moduls (124, 224, 324, 424) und Anschlussmittel (166.1-166.12, 167.1-167.4) zum Anschluss der elektronischen Einheit (100, 200, 300, 400) an das elektronische Modul (124, 224, 324, 424) umfasst, wobei diese Mittel auf einer Anschlussfläche (160) münden, die zu dem Aufnahmefach (104, 204, 304, 404) gehört und sich parallel zur Einführrichtung (P') erstreckt.

2. Elektronische Einheit (100, 200, 300, 400) nach Anspruch 1, bei der die Versorgungsmittel (165, 265, 365, 465) einen ersten leitenden Bereich (161, 261, 361, 461) und einen zweiten leitenden Bereich (162, 262, 362, 462) umfassen, die zu beiden Seiten einer Mittellinie (163) der Anschlussfläche (160, 260, 360, 460) angeordnet sind, wobei einer der ersten und zweiten leitenden Bereiche (161, 261, 361, 461) der positive Pol der Stromversorgung des elektronischen Moduls ist, wobei der andere der ersten und zweiten leitenden Bereiche (162, 262, 362, 462) der negative Pol der Stromversorgung des elektronischen Moduls ist.

3. Elektronische Einheit (100, 200, 300, 400) nach Anspruch 2, bei der sich die leitenden Bereiche (161, 261, 361, 461, 162, 262, 362, 462) in einer Richtung parallel zur Mittellinie (163) erstrecken.

4. Elektronische Einheit (100, 200 300, 400) nach einem der vorhergehenden Ansprüche, bei der die Anschlussfläche (160, 260, 360, 460) zumindest teilweise einen Überzug umfasst, der die Reibungen (168) reduziert.

5. Elektronische Einheit (100, 200, 300, 400) nach einem der vorhergehenden Ansprüche, bei der die Anschlussmittel (166.1-166.12, 167.1-167.4) zum Anschluss des elektronischen Moduls an die elektronische Einheit mindestens einen Magnetkoppler (166.1-166.12) umfassen.

6. Elektronische Einheit (100, 200, 300, 400) nach einem der vorhergehenden Ansprüche, bei der die Anschlussmittel (166.1-166.12, 167.1-167.4) zum Anschluss des elektronischen Moduls an die elektronische Einheit mindestens einen Optokoppler (167.1-167.4) umfassen.

7. Elektronische Einheit (100, 200, 300, 400) nach einem der vorhergehenden Ansprüche, bei der eine Fläche des Faches, die der Anschlussfläche gegenüberliegt, mindestens ein elastisches Element (170.1-170.3) umfasst, das ausgebildet ist, um eine kontakterzeugende Kraft auf die Anschlussfläche (160, 260, 360, 460) auszuüben.

8. Elektronisches Modul (124, 224, 324, 424), umfassend mindestens ein Einführende (125, 126, 225, 226, 325, 326, 425, 426) zum Einführen in ein Fach (104, 204, 304, 404) einer elektronischen Einheit (100, 200, 300, 400) in zwei entgegengesetzte Richtungen einer Einführrichtung (P'), Verbindungsmittel (171, 172, 271, 272, 371, 372, 471, 472) zur Verbindung mit einer Stromversorgung (165, 265, 365, 465) und Anschlussmittel (175.1-175.12, 176.1-176.4) zum Anschluss an die elektronische Einheit (100, 200, 300, 400), wobei die Verbindungsmittel zur Verbindung mit einer Stromversorgung (165, 265, 365, 465) und die Anschlussmittel (175.1-175.12, 176.1-176.4) zum Anschluss an die elektronische Einheit (100, 200, 300, 400) auf einer Anschlussfläche (127, 227, 327, 427) münden, die zum elektronischen Modul (124, 224, 324, 424) gehört, wobei sich die Anschlussfläche (127, 227, 327, 427) parallel zur Einführrichtung (P') erstreckt.

9. Elektronisches Modul (124, 224, 324, 424) nach Anspruch 8, bei dem die Verbindungsmittel zur Verbindung mit der Stromversorgung (165, 265, 365, 465) einen ersten flexiblen Kontakt (171, 271, 371, 471) und einen zweiten flexiblen Kontakt (172, 272, 372, 472) umfassen, die zu beiden Seiten einer Mittellinie (173) der Anschlussfläche (127, 227, 327, 427) zum Anschluss an die elektronische Einheit (100, 200, 300, 400) angeordnet sind.

10. Elektronisches Modul (124, 224, 324, 424) nach Anspruch 9, bei dem sich die flexiblen Kontakte (171, 172, 271, 272, 371, 372, 471, 472) in einer Richtung parallel zur Mittelline (173) erstrecken.

11. Elektronisches Modul (124, 224, 324, 434) nach einem der Ansprüche 8 bis 10, bei dem die Verbindungsmittel (171, 172, 271, 272, 371, 372, 471, 472) zur Verbindung mit einer Stromversorgung Mittel (181, 281, 381, 481) umfassen, um unabhängig von der Polarität der Spannung, die an den Verbindungsmitteln (171, 172, 271, 272, 371, 372, 471, 472) zur Verbindung mit einer Stromversorgung (165, 265, 365, 465) angelegt ist, eine konstante Versorgungspolarität wiederherzustellen.

12. Elektronisches Modul (124, 224, 324, 424) nach einem der Ansprüche 8 bis 11, umfassend Mittel (182, 282, 382, 482), die mit den Verbindungsmitteln (171, 172, 271, 272, 371, 372, 471, 472) zur Verbindung mit einer Stromversorgung (165, 265, 365, 465) verbunden und ausgebildet sind, um eine Kommunikationsrichtung der Anschlussmittel (175.1-175.12, 176.1-176.4) zum Anschluss an die elektronische Einheit (100, 200, 300, 400) zu ändern.

13. Elektronisches Modul (124, 224, 324, 424) nach einem der Ansprüche 8 bis 12, bei dem die Anschlussmittel (175.1-175.12, 176.1-176.4) zum Anschluss an die elektronische Einheit (100, 200, 300, 400) einen Magnetkoppler (175.1-175.12) umfassen.

14. Elektronisches Modul (124, 224, 324, 424) nach einem der Ansprüche 8 bis 12, bei dem die Anschlussmittel (175.1-175.12, 176.1-176.4) zum Anschluss an die elektronische Einheit (100, 200, 300, 400) einen Optokoppler (176.1-176.4) umfassen.

15. Luftfahrzeug, umfassend einen Rumpf, der mindestens eine elektronische Einheit nach einem der Ansprüche 1 bis 7 umfasst.

16. Luftfahrzeug nach Anspruch 15, umfassend mehrere elektronische Einheiten, die in dem Rumpf verteilt sind, wobei der Rumpf durch einen Boden in ein oberes Volumen und ein unteres Volumen unterteilt ist, in dem sich Träger erstrecken, die den Boden stützen und die mit dem Rumpf und dem Boden zwei seitliche Aufnahmen begrenzen, die einen Querschnitt haben, der im Wesentlichen dreieckig ist, und die sich parallel zu einer Längsrichtung des Rumpfes erstrecken, wobei die elektronischen Einheiten in mindestens einer der seitlichen Aufnahmen angeordnet sind.

## Claims

1. An electronic unit (100, 200, 300, 400) comprising a box (101) defining a reception compartment (104, 204, 304, 404) for receiving an electronic module (124, 224, 324, 424) in two mutually opposite directions along an insertion axis (P'), the compartment including electrical power supply means (165, 265, 365, 465) for powering the electronic module (124, 224, 324, 424) and connection means (166.1-166.12, 167.1-167.4) for connecting the electronic unit (100, 200, 300, 400) to the electronic module (124, 224, 324, 424), these means extending onto a connection face (160) forming part of the reception compartment (104, 204, 304, 404) and extending parallel to the insertion axis (P').

2. An electronic unit (100, 200, 300, 400) according to claim 1, wherein the power supply means (165, 265, 365, 465) comprise a first conductive area (161, 261, 361, 461) and a second conductive area (162, 262, 362, 462) arranged on opposite sides of a middle line (163) of the connection face (160, 260, 360, 460), one of the first and second conductive areas (161, 261, 361, 461) being the positive pole of the electrical power supply of the electronic module, the other one of the first and second conductive areas (162, 262, 362, 462) being the negative pole of the electrical power supply of the electronic module.

3. An electronic unit (100, 200, 300, 400) according to claim 2, wherein the conductive areas (161, 261, 361, 461, 162, 262, 362, 462) extend along respective axes parallel to the middle line (163).

4. An electronic unit (100, 200, 300, 400) according to any preceding claim, wherein the connection face (160, 260, 360, 460) is coated at least in part by a friction-reducing coating (168).

5. An electronic unit (100, 200, 300, 400) according to any preceding claim, wherein the connection means (166.1-166.12, 167.1-167.4) for connecting the electronic module to the electronic unit comprise at least one magnetic coupler (166.1-166.12).

6. An electronic unit (100, 200, 300, 400) according to any preceding claim, wherein the connection means (166.1-166.12, 167.1-167.4) for connecting the electronic module to the electronic unit comprise at least one optical coupler (167.1-167.4).

7. An electronic unit (100, 200, 300, 400) according to any preceding claim, wherein a face of the compartment opposite from the connection face includes at least one resilient element (170.1-170.3) arranged to exert a contact-making force against the connection face (160, 260, 360, 460).

8. An electronic module (124, 224, 324, 424) having at least one insertion end (125, 126, 225, 226, 325, 326, 425, 426) for insertion into a compartment (104, 204, 304, 404) of an electronic unit (100, 200, 300, 400) along two opposite directions of an insertion axis (P'), connection means (171, 172, 271, 272, 371, 372, 471, 472) for connection to an electrical power supply (165, 265, 365, 465) and connection means (175.1-175.12, 176.1-176.4) for connection to an electronic unit (100, 200, 300, 400), the connection means for connection to an electrical power supply (165, 265, 365, 465) and the connection means (175.1-175.12, 176.1-176.4) for connection to the electronic unit (100, 200, 300, 400) extending on a connection face (127, 227, 327, 427) forming part of the electronic module (124, 224, 324, 424), the connection face (127, 227, 327, 427) extending parallel to the insertion axis (P').

9. An electronic module (124, 224, 324, 424) according to claim 8, wherein the connection means for connection to an electrical power supply (165, 265, 365, 465) comprise a first flexible contact (171, 271, 371, 471) and a second flexible contact (172, 272, 372, 472) arranged on opposite sides of a middle line (173) of the connection face (127, 227, 327, 427) for connection to the electronic unit (100, 200, 300, 400).

10. An electronic module (124, 224, 324, 424) according to claim 9, wherein the flexible contacts (171, 172, 271, 272, 371, 372, 471, 472) extend along respective axes parallel to the middle line (173).

11. An electronic module (124, 224, 324, 424) according to any one of claims 8 to 10, wherein the connection means (171, 172, 271, 272, 371, 372, 471, 472) for connection to an electrical power supply include means (181, 281, 381, 481) for restoring a constant power supply polarity regardless of the polarity of the voltage applied to the connection means (171, 172, 271, 272, 371, 372, 471, 472) for connection to an electrical power supply (165, 265, 365, 465) .

12. An electronic module (124, 224, 324, 424) according to any one of claims 8 to 11, comprising means (182, 282, 382, 482) connected to the connection means (171, 172, 271, 272, 371, 372, 471, 472) for connection to an electrical power supply (165, 265, 365, 465) and shaped to modify a direction of communication of the connection means (175.1-175.12, 176.1-176.4) for connection to the electronic unit (100, 200, 300, 400).

13. An electronic module (124, 224, 324, 424) according to any one of claims 8 to 12, wherein the connection means (175.1-175.12, 176.1-176.4) for connection to the electronic unit (100, 200, 300, 400) comprise a magnetic coupler (175.1-175.12).

14. An electronic module (124, 224, 324, 424) according to any one of claims 8 to 12, wherein the connection means (175.1-175.12, 176.1-176.4) for connection to the electronic unit (100, 200, 300, 400) comprise an optical coupler (176.1-176.4).

15. An aircraft having a fuselage containing at least one electronic unit according to any one of claims 1 to 7.

16. An aircraft according to claim 15, including a plurality of electronic units distributed in the fuselage, the fuselage being subdivided by a floor into a top volume and a bottom volume in which girders extend supporting the floor and co-operating with the fuselage and the floor to define two lateral housings that are of substantially triangular cross-section and that extend parallel to a longitudinal axis of the fuselage, the electronic units being arranged in at least one of the lateral housings.
